Europäisches Patentamt

European Patent Office

Office européen des brevets

(19)

(11) Numéro de publication: **0 002 161**
**B1**

(12) **FASCICULE DE BREVET EUROPEEN**

(45) Date de publication du fascicule du brevet: **02.11.83**

(21) Numéro de dépôt: **78400192.7**

(22) Date de dépôt: **17.11.78**

(51) Int. Cl.³: **H 04 R 17/00,**
**H 01 L 41/00,**
**F 42 C 11/02,**
**H 03 F 13/00, H 03 H 9/00,**
**G 01 J 5/38, F 04 B 17/00**

(54) **Dispositif transducteur piezoélectrique et son procédé de fabrication.**

(30) Priorité: **17.11.77 FR 7734589**

(43) Date de publication de la demande:
**30.05.79 Bulletin 79/11**

(45) Mention de la délivrance du brevet:
**02.11.83 Bulletin 83/44**

(84) Etats contractants désignés:
**DE GB NL**

(56) Documents cités:
**DE - A - 1 614 600**
**DE - A - 2 344 199**
**DE - B - 1 257 997**
**DE - C - 875 212**
**FR - A - 1 455 140**
**FR - A - 2 257 356**
**FR - A - 2 303 436**
**GB - A - 1 312 879**
**GB - A - 1 377 891**
**GB - A - 1 464 555**
**US - A - 3 031 968**
**US - A - 3 816 774**
**US - A - 4 056 742**

(73) Titulaire: **THOMSON-CSF**
**173, Boulevard Haussmann**
**F-75379 Paris Cedex 08 (FR)**

(72) Inventeur: **Lemonon, Claire**
**"THOMSON-CSF" - SCPI 173, bld Haussmann**
**F-75360 Paris Cedex 08 (FR)**
Inventeur: **Micheron, François**
**"THOMSON-CSF" - SCPI 173, bld Haussmann**
**-75360 Paris Cedex 08 (FR)**
Inventeur: **Wang, Pierre**
**"THOMSON-CSF" - SCPI 173, bld Haussmann**
**F-75360 Paris Cedex 08 (FR)**

(74) Mandataire: **Wang, Pierre et al,**
**THOMSON-CSF SCPI 173, Bld Haussmann**
**F-75379 Paris Cedex 08 (FR)**

(56) Documents cités:
**IBM TECHNICAL DISCLOSURE BULLETIN, vol.
20, no. 2, juillet, 1977, New York, US, W. T.
CHEN et al.: "Ink jet head", pages 504, 505**
**PATENT ABSTRACTS OF JAPAN, vol. 1, no. 57,
juin 1977, page 3744 E76**
**PATENT ABSTRACTS OF JAPAN, vol. 1, no. 86,
11 août 1977, page 1901 E77**
**PATENT ABSTRACTS OF JAPAN, vol. 1, no. 88,
16 août 1977, page 2056 E77**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

Dispositif transducteur piezoelectrique et son procede de fabrication

La présente invention se rapporte aux dispositifs utilisant comme élément transducteur une feuille de polymère piézoélectrique munie sur ses deux faces d'électrodes. L'effet piézoélectrique se manifeste grâce à un traitement du polymère qui consiste à étirer ses chaînes macromoléculaires dans une direction prédéterminée et à soumettre la feuille étirée à un champ électrique de polarisation. Les polymères dans lesquels on peut développer un tel effet piézoélectrique sont nombreux, mais à titre indicatif on peut citer le fluorure de polyvinylidène (PVF$_2$), le fluorure de polyvinyle (PVF), connus du document GB—A— 1 377 891, le chlorure de polyvinyle (PVC) et aussi les mélanges de ces polymères.

Les transducteurs piézoélectriques sont généralement fabriqués à partir d'un film plan de polymère piézoélectrique dont les deux faces ont reçu une métallisation. Ce film préalablement étiré et polarisé est utilisé pour confectionner des éléments transducteurs ayant une forme développable, par exemple cylindrique ou polyhédrale. Lorsque la forme est développable, il est nécessaire de prévoir un moyen de maintien du film piézoélectrique, car ce dernier, du fait de sa minceur, a tendance à fléchir sous son propre poids. Avec une structure vibratoire dépourvue de rigidité, il est difficile de convertir les allongements de sa surface en volume déplacé sans faire appel à une moyen de maintien approprié. La présence du moyen de maintien assurant la tenue du film de polymère piézoelectrique ou sa mise sous tension entraîne une complication inutile de la structure du dispositif transducteur. Ce moyen de maintien peut également influer défavorablement sur les propriétés rayonnantes du film de polymère piézoélectrique. Comme le film de polymère piézo-électrique est plan à l'origine, il est difficile d'obtenir qu'il se déplace suivant la normale à ses faces d'une manière uniforme et linéaire en fonction de la tension appliquée.

Le document US—A3 816 774 décrit un transducteur à structure bimorphe, plane à l'origine et qui a été formée à chaud afin d'accroître ses propriétés de flexion. Le document FR—A—2 303 436 décrit une structure monocouche issue d'une feuille pliée en accordéon.

En vue de pallier ces inconvénients, l'invention prévoit de faire subir à un film de polymère une opération de thermoformage, afin d'obtenir au moins localement un élément transducteur dont la forme non développable soit autoportante. L'étirement qui résulte du thermoformage provoque une extension des chaînes macromoléculaires, laquelle est indispensable à la manifestation de l'effet piézoélectrique. La polarisation électrique du film thermoformé et le dépôt d'électrodes sur ses faces principales permettent d'obtenir des déplacements cumulatifs ou au contraire d'en limiter l'étendue.

L'invention a pour objet un dispositif transducteur formé d'un film monocouche de matériau polymère susceptible de présenter des propriétés piézoélectriques lorsqu'il est étiré dans son plan et polarisé électriquement par un champ de direction normale à ses faces, caractérisé en ce que ce film comporte au moins un élément transducteur constitué par une portion dudit film dans laquelle au moins une protubérance a été créée par thermoformage, les parois ainsi étirées de cette protubérance constituant une structure autoportante de forme non développable sur laquelle sont placées des électrodes formant condensateur.

L'invention a également pour objet un procédé de fabrication d'un dispositif transducteur, caractérisé en ce qu'il consiste: à thermoformer au moins une protubérance dans un film de matériau polymère susceptible de présenter des propriétés piézoélectriques lorsqu'il est étiré dans son plan et polarisé électriquement par un champ de direction normale à ses faces; à polariser électriquement la paroi étirée de cette protubérance et à placer cette paroi entre des électrodes formant condensateur.

L'invention sera mieux comprise au moyen de la description ci-après et des figures annexées parmi lesquelles:

la figure 1 est une vue isométrique partielle d'un dispositif transducteur piézoélectrique conforme à l'invention;

la figure 2 est une figure explicative;

la figure 3 représente une première phase du procédé de fabrication selon l'invention;

la figure 4 représente une autre phase du procédé de fabrication selon l'invention;

la figure 5 représente une variante du procédé de fabrication selon l'invention;

la figure 6 représente une autre variante du procédé de fabrication selon l'invention;

la figur 7 représente un élément transducteur à ondulations annulaires et son mode de polarisation;

la figure 8 représente un fragment de l'élément transducteur de la figure 7 et sa déformation sous l'influence d'une tension excitatrice;

la figure 9 représente un dispositif transducteur assurant la propulsion d'un fluide;

la figure 10 représente un dispositif transducteur destiné à la détection d'un rayonnement infrarouge;

la figure 11 représente un dispositif transducteur utilisable comme écouteur;

la figure 12 représente un dispositif transducteur utilisable comme microphone;

la figure 13 représente un dispositif transducteur équipant un projectile en vue de sa mise à feu;

la figure 14 représente un dispositif transducteur équipant un haut-parleur électrodynamique;

la figure 15 représente plusieurs organes de transmission de signal électrique.

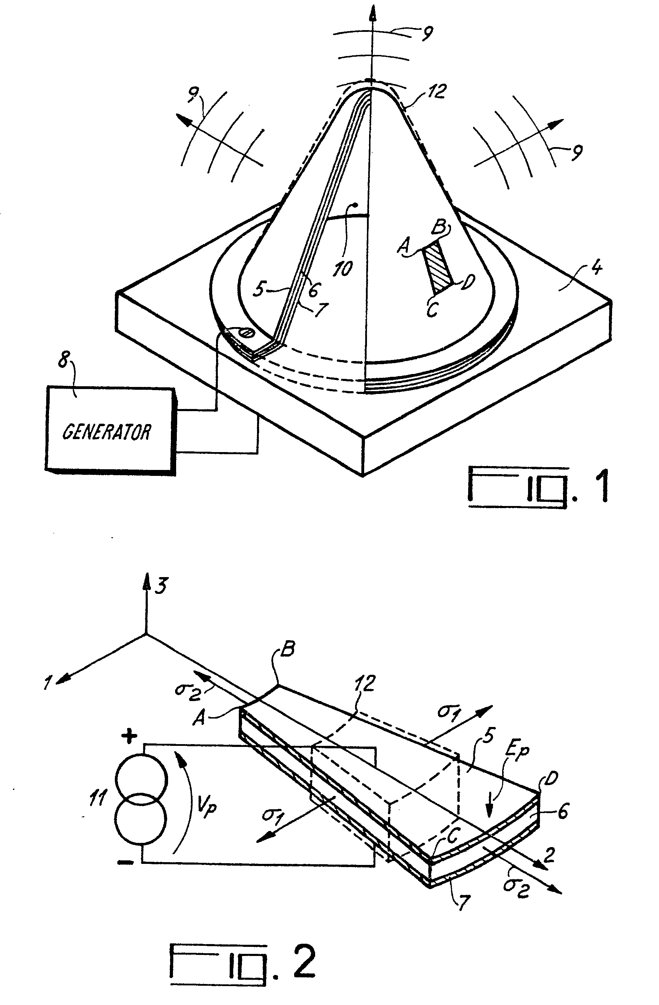

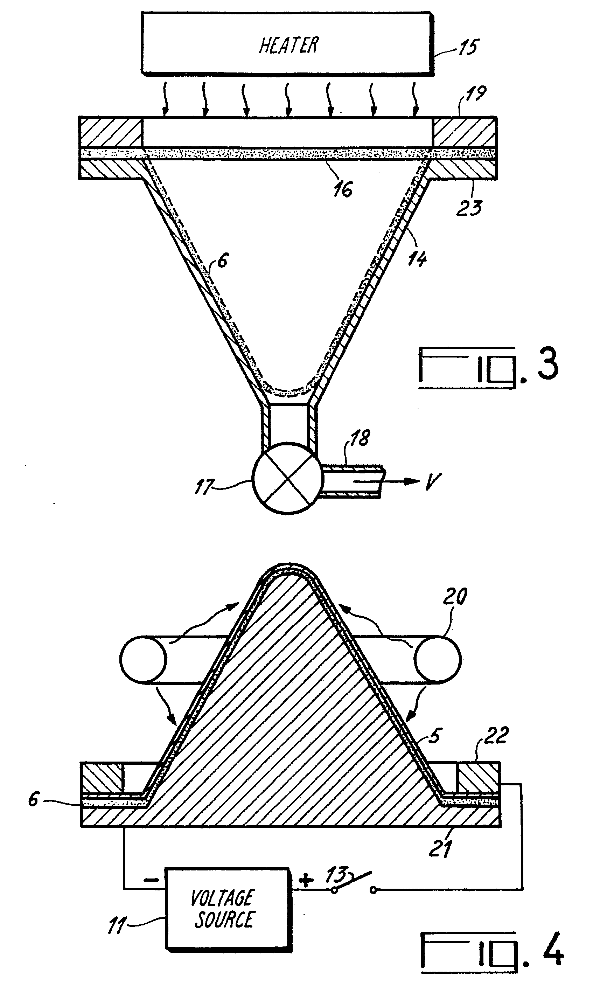

Sur la figure 1, on peut voir un dispositif transducteur permettant de rayonner des ondes de compression 9 dans un milieu fluide lorsqu'on lui applique une tension électrique alternative produite par un générateur 8. Un tel transducteur électromécanique se prête à un fonctionnement inverse, c'est-à-dire qu'étant excité mécaniquement au moyen d'ondes de compression, il peut fournir une tension électrique alternative. Pour fixer les idées, nous adopterons le fonctionnement en émetteur d'ondes acoustiques. Cet émetteur se présente sous la forme d'une protubérance en forme de dôme qui repose par son reboard annulaire sur un support 4. La paroi du dôme est constituée par un film de polymère thermoformé 6 et par des électrodes 5 et 7 déposées sur les deux faces du film 6. Pour confectionner le dôme 5, 6, 7, on a sélectionné une feuille de polymère susceptible de présenter des propriétés piézoélectriques lorsqu'il est étiré dans son plan et polarisé électriquement par un champ de direction normale à ses faces. La feuille de polymère est initialement plane et dépourvue de propriétés piézoélectriques. Par une opération de thermoformage décrite ci-après, on peut lui donner la forme d'une protubérance cônique. Après une polarisation électrique appropriée, le film thermoformé 6 est recouvert sur ses deux faces de dépôts conducteurs 5 et 7. L'ensemble obtenu, excité électriquement par le générateur 8, est le siège de pulsations 12 entraînant alternativement une dilatation et une contraction du dôme. Le volume d'air 10 compris entre le dôme 5, 6, 7 et le support 4 est simplement comprimé. Par contre, la face extérieure du dôme 5, 6, 7 rayonne des ondes sonores 9 à la fréquence de la tension excitatrice fournie par le générateur 8. Le fonctionnement en dôme pulsant du dispositif de la figure 1 peut être mieux compris en considérant un de ses éléments étirés A, B, C, D. Cet élément ABCD est illustré à grande échelle sur la figure 2.

Cette figure représente en pointillé un volume élémentaire 12 dans l'état initial, c'est-à-dire, avant que l'étirage engendré par le thermoformage ne l'ait amené à la forme ABCD. En se rapportant au système d'axes 1, 2, 3, on voit que le volume 12 qui contenait des chaînes macromoléculaires en roulées en hélice et orientées en tous sens a subi des tensions $T_1$ et $T_2$ contenues dans le plan 1, 2. Il en résulte que l'élément ABCD a cessé d'être isotrope. Ses chaînes macromoléculaires se sont déployées dans les directions d'étirement correspondant aux tensions mécaniques $T_1$ et $T_2$. Cette anisotropie de structure du polymère 6 étant acquise, une tension de polarisation $V_p$ produite par le générateur de polarisation 11 est appliquée aux électrodes 5 et 7. Un champ électrique $E_p$ est ainsi créé au sein du polymère 6. Il en résulte un réarrangement des charges électriques au sein des chaînes macromoléculaires.

Ayant subi les deux étapes de traitement mentionnées ci-dessus, l'élément polymère 6 a acquis des propriétés piézoélectriques. En particulier, les constantes piézoélectriques $d_{31}$, $d_{32}$, $d_{33}$ ont acquis des valeurs non nulles, ce qui explique qu'une tension électrique excitatrice appliquée aux électrodes 5 et 7 engendre des déplacements des bords de l'élément ABCD dans des sens tels que le volume 10 contenu à l'intérieur du dôme de la figure 1 tend à augmenter ou à diminuer. On voit donc que la thermoformage d'une fibre polymère peut donner naissance à une protubérance dont l'eveloppe forme une coque autoportante qui, convenablement polarisée, peut répondre à une tension excitatrice par un déplacement d'ensemble tendant à reproduire l'ultime phase de déformation que lui a imposé le thermoformage. En présence d'une tension excitatrice alternative, on assiste à une respiration du dôme qui vibre dans toutes ses parties.

Les matériaux polymères appropriés à la confection d'un transducteur piézoélectrique sont nombreux. On peut citer notamment: le chlorure de polyvinyle (PVC), le fluorure de polyvinylidène ($PVF_2$) et le fluorure de polyvinyle (PVF). Comme on le verra par la suite, l'effet piézoélectrique n'est pas le seul à être rendu effectif par les phases de thermoformage et de polarisation électrique. Ces matériaux traités présentent en effet des propriétés piézoélectriques permettant de les utiliser comme détecteurs de rayonnement infrarouge. Le thermoformage par pression différentielle de tels matériaux est connu du document DE—C— 875 212.

Sur la figure 3 on peut voir un dispositif permettant de réaliser le thermoformage du dôme piézoélectrique de la figure 1.

Ce dispositif comprend un moule 14 en forme d'entonnoir dont le fond est relié par l'intermédiaire d'une valve 17 à une conduite 18 en relation avec une pompe à vide V. La partie supérieure du moule 14 est munie d'une collerette annulaire 23. La valve 17 étant fermée, on pose sur la collerette 23 un film plan 16 de polymère, par exemple du chlorure de polyvinyle. Un anneau 19 coopérant avec la colerette 23 pince fortement le film 16 et assure du même coup l'étanchéité de la cellule constituée par la portion cônique du moule 14 et par le film 16. Un dispositif de chauffage 15 assure le ramollissement de la matière constituant le film 16. En ouvrant la valve 17, l'air contenu dans la cellule étanche est pompé progressivement, ce qui provoque l'affaissement du film 16 sous l'action de la pression atmosphérique. Pendant l'opération de thermoformage, le film 16 subit un étirement important avec un accroissement de surface de plusieurs fois sa valeur. Lorsque l'opération prend fin, le film 16 est venu en contact avec la paroi cônique du moule 14. Ce dernier étant à la température ambiante, le film thermoformé se fige dans la forme du dôme 6 représenté en pointillé.

Pour polariser électriquement le dôme thermoformé, on peut utiliser le dispositif de la figure 4. Il comprend un support conducteur 21 sur lequel le dôme 6 préformé vient s'ajuster exactement. Préalablement, on a déposé sur la face externe du dôme 6 une électrode 5. Le dôme étant en position sur son support 21, son rebord est maintenu en place par un anneau conducteur 22. L'anneau 22 et le support 21 sont reliés par un interrupteur 13 à une source de tension continue 11. Le dôme est chauffé au moyen d'une source de chaleur 20 et pendant une durée prédéterminée on lui applique la tension de polarisation en fermant l'interrupteur 13. Le support empêche qui le dôme ne s'effondre ou se recroqueville sous l'effet du ramollissement; il coopère aussi avec l'électrode 5 pour créer selon l'épaisseur de la paroi du dôme le champ électrique de polarisation $E_p$. Le champ $E_p$ est intense, mais il ne doit pas provoquer la disrupture du diélectrique constituant le dôme thermoformé.

Après polarisation électrique, le dôme thermoformé est revêtu sur sa face interne d'un dépôt conducteur qui constitue l'électrode 7. Il ne rese plus qu'à l'attacher au support 4, lequel peut être conducteur pour établir commodément la connexion vec l'électrode 7. On peut également déposer l'électrode interne avant mise sous tension L'accrochage des électrodes sur le film polymère est favorisé si l'on traite les faces par décharge Corona.

A titre d'exemple non limitatif, on a réalisé conformément aux schémas des figures 1, 3 et 4 un hautparleur destiné à la reproduction des fréquences acoustiques supérieures à 5 kHz. Au départ, on a choisi une feuille de PVC d'environ 40 $\mu$m d'épaisseur. Cette feuille a été thermoformée par aspiration à 90° C au moyen d'un moule cônique ayant un diamètre de base de 8 cm et une hauteur de 7 cm. La pointe arrondie du dôme thermoformé se raccorde à la partie cônique selon une circonférence de diamètre égal à 1,5 cm. Le dôme est ensuite métallisé à froid sur sa face extérieure au moyen de peinture à l'argent. Il est ensuite placé sur le moule 21 de la figure 4 où il subit à 120°C une polarisation électrique par application d'une tension continue de l'ordre de 3000 V. La tension est appliquée pendant une heure, et avant de couper cette tension, on laisse refroidir le dôme. La face interne du dôme est revêtue à son tour d'une couche de peinture à l'argent. L'ensemble est alors monté sur un écran rectangulaire mesurant 20 cm×30 cm et muni d'une ouverture circulaire. Le dôme est fixé par son rebord à cette ouverture. En appliquant entre les électrodes 5 et 7 une tension alternative de 100 V crête à crête, on a obtenu un niveau acoustique suffisant pour que ce hautparleur puisse servir de tweeter dans une enceinte acoustique classique. Tel quel, le haut- parleur possède une courbe de réponse présentant un maximum autour de la fréquence 10 kHz. Cette pointe est dûe à la résonance naturelle du dôme. On peut la faire disparaître en plaçant à l'intérieur du dôme un cône taillé dans une mousse de polyuréthane. Ainsi corrigée, la courbe de réponse ne présente plus d'accident notable. Le rayonnement est très peu directif, car le dôme fonctionne plutôt comme une sphère pulsante que comme un simple piston plan.

L'exemple qui vient d'être mentionné montre que le thermoformage permet d'obtenir une structure vibrant d'une seule pièce et qui est motrice dans toutes ses parties. Cette structure est auto-portante, car elle épouse la forme d'une coque. La forme étant parfaitement reproductible, les caractéristiques du transducteur le sont également. De plus, comme ce hautparleur ne comporte ni aimant ni bobine mobile, sa fabrication est facile et très peu coûteuse.

Dans ce qui précède, on à vu que le thermoformage associé à la polarisation électrique permettaient de former à partir d'un film de polymère une protubérance de forme cônique pouvant constituer un excellent transducteur électroacoustique. Un tel transducteur convient parfaitement pour exciter ou recueillir dans l'air des ondes acoustiques. Il rend encore mieux les mêmes services, lorsqu'il s'agit d'émettre ou de recevoir dans l'eau des ondes ultrasonores. Dans ce cas, comme le matériau qui le constitute présente une impédance mécanique du même ordre que celle des liquides où s'effectue la propagation des ondes, il perturbe peu la propagation des ondes, ce qui constitue un avantage important.

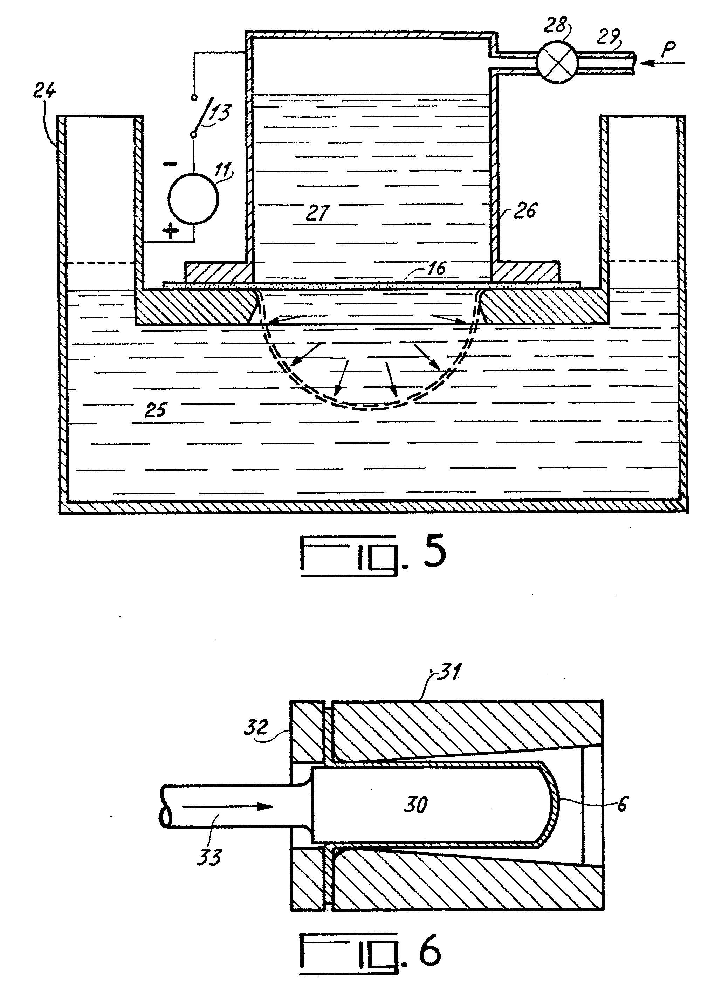

Sur la figure 5, on peut voir un dispositif permettant d'obtenir par thermoformage une protubérance en forme de calotte. Ce dispositif comporte une cuve 24 renfermant un liquide 25. Le centre de la cuve 24 comporte une assise à bords remontants sur laquelle est posé le film de polymère 16 à thermoformer. Une ouverture circulaire centrale percée dans l'assise de la cuve 24 délimité la portion du film 16 qui doit subir le thermoformage. Une cloche 26 fortement appuyée sur le film 16 le retient par ses bords. La cloche 26 renferme un liquide 27 qui fait office de piston liquide pour thermoformer la partie du film 16 qui surplombe l'ouverture circulaire pratiquée dans l'assise de la cuve 24. La cloche 26 communique par une valve 28 avec une conduite 29 de gaz sous forte pression P. Les liquides 25 et 27 sont chauffés à une température favorable au thermoformage grâce à des éléments chauffants non représentés. Les liquides 25 et 27 sont rendus électriquement conducteurs au moyen d'ions appropriés. La cuve 24 et la cloche 26 sont relisées en matériaux conducteurs. Elles sont électriquement isolées l'une de l'autre par le film 16 qui joue aussi le rôle de joint d'étanchéité. Une source de tension continue 11 reliée à la cuve 24 fournit la tension de polarisation du film 16. L'autre borne de la source 11 est reliée par l'interrupteur 14 à la cloche. On voit qu'en fermant l'interrupteur 13, la tension de polarisation se trouve appliquée directement aux deux faces du film 16.

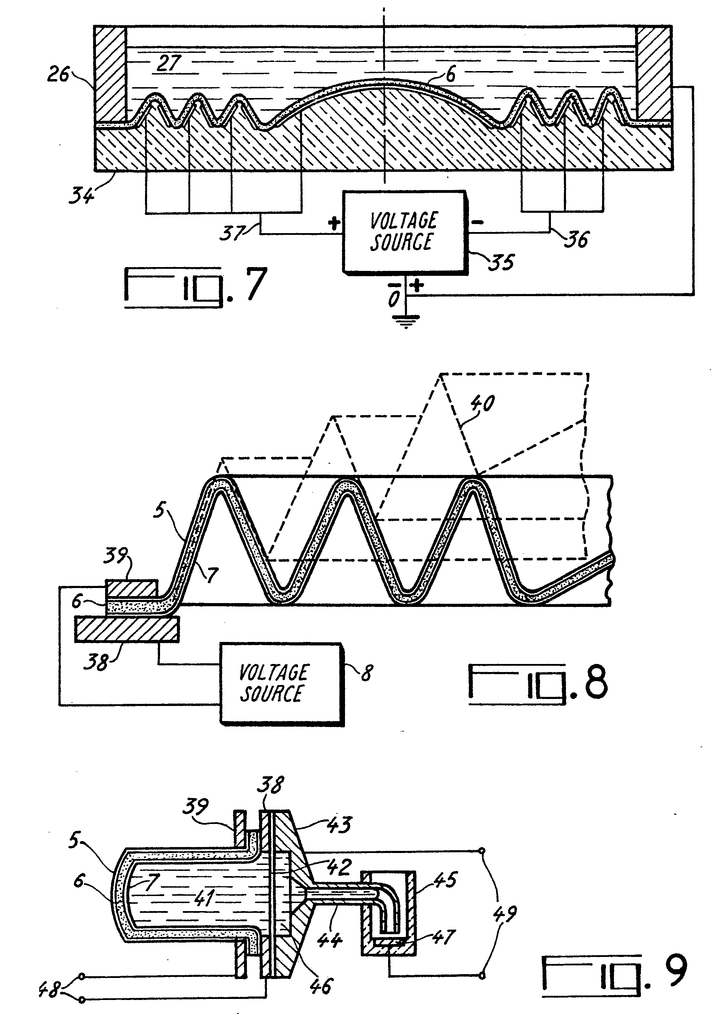

Lorsque la température de thermoformage est atteinte dans toute l'étendue du film 16, on ouvre la valve 28. La pression P est transmise par le liquide 27 au film 16 qui s'étire vers le bas en une protubérance en forme de calotte sphérique. Cette forme est obtenue sans l'aide d'aucun moule, car la poussée du liquide 27 est hydrostatique. Pendant le thermoformage la polarisation électrique est effective, mais on peut poursuivre son action après que la forme désirée soit atteinte (en pointillé sur la figure 5). Le mode de thermoformage illustré sur la figure 5 n'est pas limité à l'obtention de protubérances en forme de calotte sphérique. En réalisant l'assise de la cuve 24 au moyen d'éléments démontables, on peut envisager de thermoformer une protubérance comportant une calotte centrale entourée d'ondulations annulaires comme illustré sur la figure 7. On peut également poursuivre le therloformage d'une calotte audelà de la forme hémisphérique ou produire sur une calotte principale des petites protubérances secondaires dont les rebords prennent appui sur une cuvette percée d'ouvertures que l'on a placée en contrebas de l'assise de la cuve 24. Les protubérances secondaires peuvent servir d'ossature de renforcement.

Le montage du film 16 et le démontage de la protubérance thermoformée nécessite le transvasement des liquides 25 et 27. Ce transvasement peut se faire au moyen de réservoirs auxiliaires non représentés sur la figure 5. De même, en vue d'équilibrer les pressions agissant de part et d'autre de la structure thermoformée, on peut mettre en communication la cuve 24 et la cloche 26.

Les dispositifs de thermoformage décrits ci-dessus utilisant une poussée de gaz ou de liquide pour étirer le film de polymère. Sur la figure 6, on peut voir un dispositif de thermoformage fonctionnant par emboutissage. Il comprend un poinçon 30, une matrice 31 et une couronne 32. Cette couronne assure le pinçage du film à thermoformer sur la matrice. L'enfoncement du poinçon 30 dans la direction 33 permet d'obtenir une protubérance 6 de forme cylindrique. Dans ce cas, l'étirement reste confiné à la paroi latérale cylindrique de la protubérance car les forces de frottement empêchent le fond de celle-ci de glisser sur la tête du poinçon. Bien entendu, l'opération de thermoformage se déroule à chaud et nécessite de préférence un poinçon chauffé à la température de ramollissement du film polymère. Sans s'écarter du domaine de l'invention, le thermoformage par emboutissage à chaud peut se faire au moyen de matrices et de poinçons usinés selon un profil complexe tel que celui qui est illustré sur la figure 7.

Sur la figure 7, on a représenté un dispositif de polarisation électrique particulièrement utile pour réaliser des membranes thermoformées capables de fournir des élongations importantes.

Le film thermoformé 6 se présente sous la forme d'une protubérance centrale en forme de calotte associée à des protubérances annulaires formant des ondulations. Dans un tel cas, il est avantageux de s'arranger pour inverser le sens de la polarisation électrique lorsqu'on passe d'un flanc d'ondulation au suivant.

A cet effet, le film thermoformé est placé sur un support isolant 34 dont la face supérieure s'adapte exactement à son relief. La protubérance centrale du support 34 est métallisée jusqu'à sa base et reliée électriquement à une borne 34. Les flancs extérieures des protubérances annulaires du support 34 sont également métallisés et ces métallisations sont reliées à la borne 37. Les flancs intérieurs des protubérances annulaires du support 34 reçoivent des métallisations qui sont reliées à une autre borne 36. Une couronne conductrice 26 assure le maintien en place du film thermoformé sur son support 34. La source de tension de polarisation 35 comporte une borne de neutre 0 reliée à la couronne 26. Elle fournit une tension positive à la borne 37 et une tension égale et de signe contraire à la borne 36. Un liquide conducteur 27 recouvrant la face supérieure du film thermoformé 6 met celle-ci au potentiel de la borne de neutre. De cette manière, on obtient des champs de polarisation alternés lorsqu'on passe du flanc extérieur d'une ondulation à son flanc intérieur.

La figure 8 représente un fragment du film thermoformé 6 de la figure 7. On a déposé des électrodes 5 et 7 sur les deux faces du film 6. Ce film est pincé par son rebord entre deux couronnes conductrices 38 et 39 qui servent d'appui. La tension d'excitation est fournie par le générateur 8 relié aux couronnes 38 et 39. Sous l'effet de la tension excitatrice, les flancs des ondulations inclinés dans un sens s'allongent tandis que les flancs inclinés dans l'autre sens se raccourcissent. Il en résulte une addition des déplacements dans le sens vertical. Ce déplacement cumulé est illustré par le tracé en pointillé 40. Grâce à cette technique de polarisation, on peut réaliser un piston vibrant présentant de grandes élongations. A cet effet, il faut former à la périphérie du film 6 un grand nombre d'ondulations à la fois hautes et de faible pas. Le film thermoformé de la figure 7 convient particulièrement bien pour la réalisation de diaphragmes auto-moteurs à compliance mécanique élevée. Ces diaphragmes permettent d'étendre l'utilisation des transducteurs thermoformés aux hautparleurs destinés à reproduire le registre médium et grave avec une puissance acoustique convenable. La calotte centrale peut être plus particulièrement destinée à assurer le rayonnement non directif des fréquences élevées du spectre acoustique.

En ce qui concerne le dépôt des électrodes 5 et 7 sur les deux faces du film thermoformé 6, on peut notamment utiliser la peinture conductrice, la galvanoplastie, l'argenture chimique, l'évaporation sous vide, le choppage et la pulvérisation cathodique. Dans certaines applications, on peut limiter l'étendue des électrodes à certaines zones du film thermoformé, afin de confiner l'effet transducteur. Ceci résulte du fait que l'effet transducteur ne se trouve réalisé que dans les régions qui sont simultanément thermoformées, polarisées électriquement et revêtues d'électrodes en vis-à-vis. Cette triple conditon permet de doser l'effet piézoélectrique en jouant sur l'une des trois composantes. On peut donc réaliser séparément ou en combinaison, un thermoformage par zones, une polarisation électrique par zone ou un dépôt d'électrodes par zones.

En ce qui concerne la polarisation électrique, l'application d'un champ électrique $E_p$ n'est qu'un moyen parmi d'autres. On peut également, comme celà se pratique dans la technique des électrets réaliser une polarisation électrique du film thermoformé par décharge corona ou par implantation d'ions.

Les dispositifs transducteurs décrits ci-dessus sont utilisés comme émetteurs ou capteurs d'ondes vibratoires. Ils reçoivent ou délivrent une tension électrique alternative qui correspond à la création ou à la captation d'une pression acoustique ou ultrasonore.

Le document US—A—4 056 742 décrit un transducteur comportant une membrane ondulée développable appuyée sur des supports intermédiaires. Le document DE—A—1 614 600 décrit un relais mettant en oeuvre un élément piézoélectrique bimorphe. Le document FR—A—2 257 356 décrit un organe de poussée à structure bimorphe permettant d'émettre un jet de liquide.

Le dispositif transducteur représenté sur la figure 9 peut fonctionner sous la commande d'une tension en échelon ou en impulsion appliquée aux bornes 48. Le film thermoformé 6 épouse la forme d'une protubérance cylindrique obtenue par exemple au moyen du dispositif de la figure 6. Ses électrodes 5 et 7 se prolongent sur le rebord de la paroi cylindrique, lequel est pincé entre deux couronnes conductrices 38 et 39. Une membrane souple et isolante 42 ferme l'embouchure du corps cylindrique 5, 6, 7. Un fluide 41 remplit le volume compris entre le film polymère 5, 6, 7 et la membrane 42. Un couvercle 43 muni d'un évidement 46 est appliqué contre le membrane 46. L'évidement 46 communique avec un tube capillaire 44 et l'ensemble renferme un liquide sur lequel la membrane 46 peut exercer une poussée. Cette poussée est produite par contraction du corps cylindrique 5, 6, 7 lorsqu'il est excité par une tension électrique appliqué aux bornes 48. Il en résulte un déplacement du ménisque vers l'extrémité libre du tube capillaire 44. Sur la figure 9, l'extrémité du tube capillaire 44 débouche dans une coupelle isolante 45 dont le fond est muni d'un contact électrique 47. En supposant le capillaire 44 conducteur ainsi que le liquide qu'il renferme on voit que, lorsque ce liquide débouche du capillaire sous l'effet d'une tension de commande appliquée aux bornes 48 un contact électrique se ferme entre les bornes 49 reliées respectivement au couvercle conducteur 43 et au contact 47. Le liquide conducteur peut être avantageusement constitué par de mercure. Lorsque la tension de commande s'annule la membrane 42 reflue vers la gauche, ce qui a pour effet de rompre le contact mouillé. Le film de polymère thermoformé est donc tout indiqué pour commander un déplacement. Cependant, au lieu de faire fonctionner le dispositif 9 à la manière d'un relai électromécanique, il est possible de l'utiliser pour la projection d'un jet de liquide. Dans cette version, l'extrémité du capillaire est équipée d'une buse. De plus, une conduite d'alimentation branchée entre la buse et la membrane 42 est raccordée à une reservoir de liquide. Lorsqu'on applique aux bornes 48 une impulsion brève, un jet de liquide est projeté par la buse. Entre deux impulsions de commande le liquide éjecté est remplacé par une quantité égale fournie par le réservoir. Dans cette variante d'utilisation, la membrane 42 peut être supprimée, car le liquide provenant du réservoir peut sans inconvénient occuper tout le volume délimité par le capillaire 44, le couvercle 43 et le corps cylindrique thermoformé 5, 6, 7. En utilisant comme liquide de remplissage, une encre de fluidité convenable, le dispositif peut servir à l'inscription de caractères sur un support approprié.

Les documents GB—A—1 312 879 et GB—A—1 464 555 décrivent des détecteurs pyroélectriques basés sur l'utilisation d'un transducteur en polymère. Un détecteur mettant en oeuvre des électrodes continues et un effet piézoélectrique uniformément réparti sont décrits dans le document US—A—3 816 774.

Comme indiqué ci-dessus, à l'effet piézoélectrique s'ajoute un effet pyroélectrique qui peut être utilisé, par example pour détecter un rayonnement infrarouge.

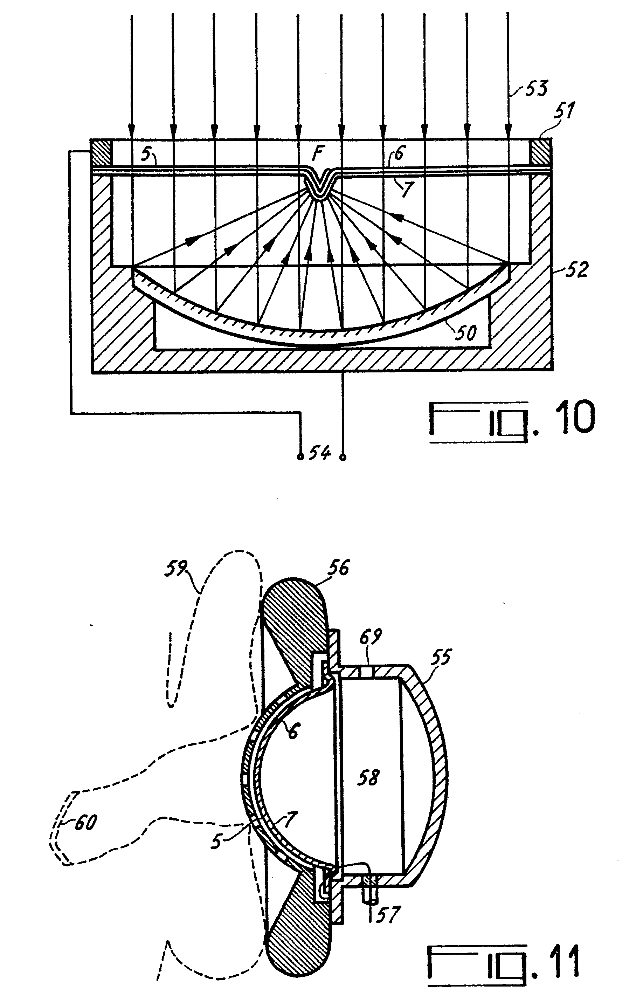

Un tel détecteur est représenté sur la figure 10. Il comprend un boîtier 52 au fond duquel est monté un miroir concave 50. Le rayonnement infrarouge incident 53 traverse un film de polymère 6 et est réfléchi au foyer F du miroir 50. La zone centrale du film 6 est thermoformée de façon à former une protubérance conique située au foyer F. Les deux faces de cette protubérance sont munies d'électrodes 5 et 7, qui se prolongent radialement vers la périphérie du film 6. Le prolongement de l'électrode 5 est en contact avec une couronne 51 et le prolongement de l'électrode 7 est en contact avec le boîtier conducteur 52. Des bornes de sortie 54 sont reliées respectivement au boîtier 52 et à la couronne 51. La face externe de la protubérance centrale est noircie, afin d'absorber aussi efficacement que possible le rayonnement infrarouge concentré par la miroir 50. L'échauffement local de la protubérance centrale préalablement polarisée entraîne l'apparition d'une tension électrique aux bornes 54. La majeure partie du filme 6 n'absorbe pas le rayonnement infrarouge incident 53. Comme de plus, elle présente une très faible conductivité thermique, la protubérance centrale peut s'échauffer sans fuite de chaleur par conduction. Le détecteur ainsi constitué présente une bonne sensibilité, une faible inertie thermique et une bonne directivité. La réalisation est particulièrement peu coûteuse et le miroir est bien protégé contre le ternissement.

Une analyse plus fine du rayonnement infrarouge peut être obtenu si l'on adopte un agencement matriciel de petites protubérances. A chaque protubérance, on fait correspondre une paire de bornes 54 qui délivre un signal représentatif d'un élément d'une image infrarouge formée sur le film 6 par le miroir 50. Une analyse cyclique des tensions recueillies permet ensuite de visualiser sur un écran la source de rayonnement infrarouge.

Le document US—A—4 056 742 décrit un transducteur utilisant un film polymère à surface développable ondulée reposant sur des supports intermédiaires. Le document "Patent Abstracts of Japan, volume 1, n° 86, 11 Août 1977, pages 1901 E 77, paragraphe 2, décrit un microphone utilisant une membrane en forme de dôme.

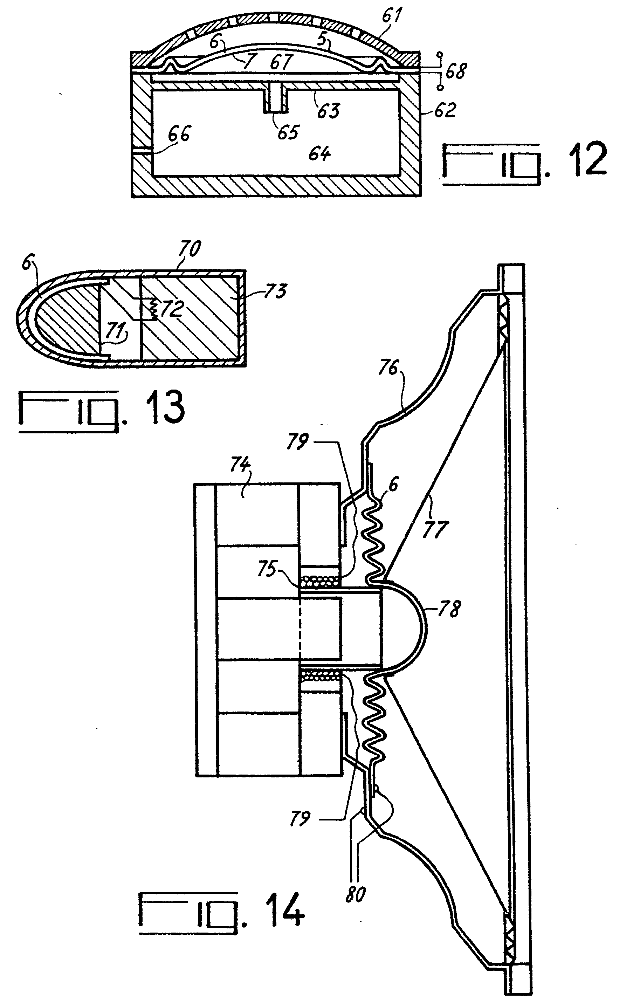

La figure 11 représente un écouteur utilisant une calotte thermoformée 6 revêtue sur ses deux faces d'électrodes 5 et 7. Le pavillon 56 compote une grille ajourée qui épouse le contour de la calotte 6. Lorsqu'il est appliqué contre le pavillon de l'oreille 59, le volume d'air compris entre le tympan 60 et la calotte 6 est réduit. L'écouteur comporte un boîtier 55 dont le rebord porte la calotte 6. Le volume d'air 58 enfermé entre la calotte 6 et le boîtier 55 forme un ressort pneumatique qui accroî la raideur de la suspension de la calotte 6. Un orifice 69 de très faible section permit d'équilibrer les pressions interne et externe, mais ce dernier n'influe pas sur les caractéristiques acoustiques de l'écouteur dans la gamme des fréquences à reproduire. Les électrodes 5 et 7 sont reliées à un câble d'alimentation 57. Le volume du conduit auditif est comprimé par le déplacement de la calotte 6 sous l'effet de la tension appliquée aux bornes du câble 57. La réponse en fréquence est relativement plate jusqu'à la fréquence naturelle de résonance de la calotte qui se situe dans l'aigu. Un remplissage du volume 58 avec de l'ouate de verre permet d'abaisser la fréquence de résonance et d'améliorer la courbe de réponse. Dans le cas d'un écouteur miniaturisé, le fait d'utiliser comme membrane une protubérance thermoformée permet d'insérer celle-ci dans le conduit auditif, le pavillon 56 prend alors la forme d'un embout. Un tel écouteur est extrêmement léger, son port est aisé et son aspect est esthétique.

La figure 12 représente un microphone dont le diaphragme 6 est constitué par un film thermoformé. La diaphragme 6 est pincé entre une grille protectrice 61 et un boîtier 62. Un orifice d'équilibrage 66 assure l'égalisation des pressions. Le boîtier 62 est muni d'une paroi séparatrice 63 au centre de laquelle est monté un évent 65. Un premier volume d'air 67 est emprisonné entre le diaphragme 6 et la paroi séparatrice 63. Un second volume d'air 64 est contenu entre le fond du boîtier 62 et la paroi séparatrice 63. Des électrodes 5 et 7 recouvrent les faces du diaphragme 6; elles sont reliées respectivement aux bornes de sorte 68. Le diaphragme 6 vibre sous l'influence de la pression acoustique incidente qui s'établit entre la grille 61 et le diaphragme 6. Aux fréquences élevées, le volume d'air 67 est seul comprimé acoustiquement, car l'inertie de l'évent s'oppose à la transmission de la pression acoustique. A plus basse fréquence, l'évent 65 vibre et ajoute son inertie à celle du diaphragme 6, mais le volume d'air 64 n'est que faiblement comprimé. Aux fréquences encore plus basses, l'inertie de l'évent 65 devient négligeable et les deux volumes d'air 67 et 64 s'additionnent de façon à ne pas trop renforcer la raideur du diaphragme. La présence des éléments acoustiques 67, 65 et 64 contribue à l'élargissement de la courbe de réponse du microphone. En mettant en ouvre les frictions au niveau de l'évent 65 et par un remplissage approprié du volume 64 avec de l'ouate de verre, on peut amortir les résonances et obtenir une courbe de réponse très régulière.

Il est connu des documents US—A—3 031 968 et DE—A—2 344 199 de mettre à feu une charge explosive en utilisant la tension électrique fournie par une pastille piézoélectrique qui réagit à la décélération d'un projectile contenant ladite charge.

Sur la figure 13, on peut voir un dôme 6 de polymère thermoformé placé dans l'ogive d'un projectile 70. On peut montrer qu'un volume de l'ordre de centimètre cube de fluorure de polyvinylidéne est capable de restituer une énergie électrique de l'ordre du joule lorsqu'il est brusquement écrasé. Cette énergie électrique est suffisante pour provoquer la mise à feu d'une charge d'explosif 73 dans laquelle est logé un allumeur électrique 72. Le dôme 6 est coincé entre la paroi de l'ogive du projectile 70 et une masse flottante 71. L'ogive et la masse flottante sont reliées à l'allumeur 72. Lorsque le projectile atteint sa cible, la brusque décélération provoque l'écrasement du dôme thermoformé et l'allumage de la charge 73.

Le document "Patent Abstracts of Japan", volume 1, n° 57, 3 Juin 1977, page 3744 E 76, paragraphe 3 décrit un haut-parleur dont la membrane est pourvue d'une suspension périphérique active.

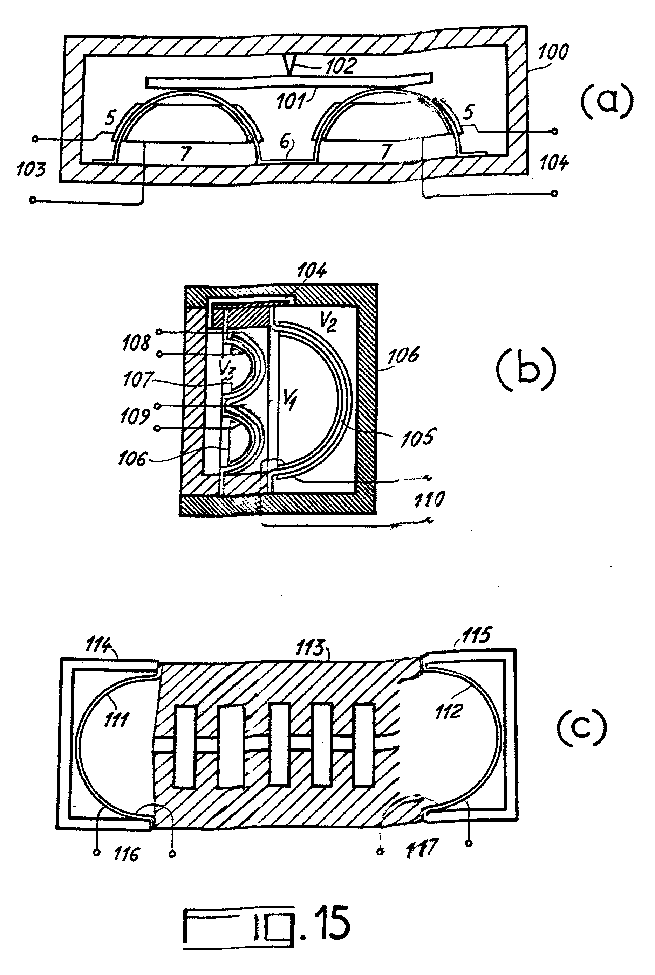

Sur la figure 14, on a représenté un transducteur électroacoustique de type classique dans lequel on utilise un transducteur piézoélectrique thermoformé conforme à l'invention. Il s'agit d'un haut-parleur électrodynamique comportant un aimant permanent 74 à entrefer annulaire, une bobine mobile 75 plongée dans cet entrefer et un cône 77 dont la suspension périphérique est fixée au rebord d'un saladier 76. En faisant circuler entre les bornes 79 de la bobine mobile 75 un courant alternatif, celle-ci se déplace suivant son axe et entraîne par son sommet le cône 77. Dans le haut-parleur normal, il est nécessaire de centrer la bobine mobile par rapport à l'entrefer au moyen d'une suspension en textile imprégné formant un diaphragme à ondulations concentriques. Conformément à l'invention, ce diaphragme est remplacé par un film polymère thermoformé 6 muni en son centre d'une calotte émissive 78. Les ondulations du diaphragme 6 et la calotte 78 sont polarisées électriquement après le thermoformage conformément au schéma de la figure 7. Des électrodes déposées sur les faces de la portion ondulée du diaphragme de centrage 6 sont reliées à des bornes de sortie 80. La calotte 78 est également munie sur ses deux faces d'électrodes reliées à des bornes d'entrée non représentées.

L'utilisation d'une suspension constituée par un diaphragme transducteur piézoélectrique thermoformé permet d'une part de rayonner les sons de fréquences élevées par la calotte 78 qui fait office de tweeter intégré au cône principal 77. D'autre part, comme le diaphragme 6 relie le saladier 76 à la bobine mobile, le déplacement de celle-ci se traduit par l'apparition d'une tension proportionnelle entre les bornes 80. En reliant la bobine mobile 75 à un amplificateur à contre réaction on peut se servir de la tension disponible entre les bornes 80 pour asservir le mouvement vibratoire du cône 77, ce qui permet d'obtenir une excellente régularité de la courbe de réponse aux basses fréquences et une diminution sensible des non-linéarités qui se produisent lorsque l'amplitude de déplacement du cône est importante.

L'exemple de la figure 14 montre qu'il est intéressant de coupler mécaniquement deux transducteurs électro-mécaniques. Etant donné sa simplicité de fabrication, le transducteur piézoélectrique thermoformé est tout indiqué pour se substituer au moteur électrodynamique 74, 75. Dans cet ordre d'idée, on peut relier mécaniquement, pneumatiquement ou hydrauliquement deux diaphragmes piézoélectriques thermoformés pour réaliser un organe de transmission de signal électrique à deux paires de bornes. Un tel organe de transmission permet de réaliser des filtres. Il peut aussi transmettre une tension de commande entre des points d'un circuit électrique qui sont portés à des potentiels très différents. A ce titre, il est beaucoup plus léger qu'un transformateur et il est susceptible de transmettre la composante·continue d'un signal. Bien entendu, un seul diaphragme thermoformé muni de deux jeux d'électrodes peut suffire à réaliser un tel organe de transmission.

Les documents FR—A—1 455 140 et DE—B—1 257 997 décrivent des moyens de couplage fluides ou solides entre transducteurs électromécaniques.

Sur la figure 15, on peut voir en (a), un organe de transmission à deux paires de bornes 103 et 104. Il comprend un boîtier 100 dans lequel est monté un film polymère thermoformé 6 à deux protubérances adjacentes munies respectivement d'électrodes 5 et 7 reliées aux bornes 103 et 104. Le couplage mécanique est assuré par un levier 101 arcbouté entre les sommets des deux calottes theremoformé et un pivot 102. En déplaçant le pivot 102 le long du levier 101, on peut ajuster le rapport de transformation.

On voit en (b) sur la figure 15 un organe de transmission à deux voies d'entrées 108 et 109 et une voie de sortie 110. Le boîtier 104 renferme trois protubérances thermoformées 105, 106 et 107 qui délimitent un volume de couplage $V_1$ et deux volumes $V_2$ et $V_3$ interconnectés par un conduit 104. Ce dispositif transducteur fournit sur la voie de sortie une combinaison linéaire des tensions appliquées aux voies 108 et 109. Suivant les polarisations électriques, on peut l'utiliser pour additionner ou soustraire deux tensions.

On voit en (c) sur la figure 15, une filtre passebas utilisant deux calottes thermoformées 111 et 112 dont les électrodes sont reliées aux paires de bornes 116 et 117. Les calottes sont coiffées par des couvercles 114 et 115 et elles sont couplées acoustiquement l'une à l'autre par un corps 113 dans lequel une suite alternée d'évents et de cavités réalise la fonction de transfert passe-bas.

## Revendications

1. Dispositif transducteur formé d'un film monocouche (6) de matériau polymère susceptible de présenter des propriétés piézoélectriques lorsqu'il est étiré dans son plan et polarisé électriquement par un champ de direction normale à ses faces, caractérisé en ce que ce film comporte au moins un élément transducteur constitué par une portion dudit film (6) dans laquelle au moins une protubérance a été créée par thermoformage, les parois ainsi étirées de cette protubérance constituant une structure autoportante de forme non développable sur laquelle sont placées des électrodes (5, 7) formant condensateur.

2. Dispositif transducteur selon la revendication 1, caractérisé en ce que l'élément transducteur comporte plusieurs protubérances.

3. Dispositif transducteur selon la revendication 1, caractérisé en ce que les protubérances sont constituées par des ondulations annulaires contigües et par un dôme central (78); l'ensemble de ces protubérances forment un diaphragme.

4. Dispositif transducteur selon la revendication 3, caractérisé en ce que les ondulations ont leurs flancs polarisés électriquement par des champs électriques de sens contraires.

5. Dispositif transducteur selon la revendication 4, caractérisé en ce que deux jeux d'électrodes sont déposés sur les protubérances; l'un de ces jeux recouvrant les faces des ondulations annulaires et l'autre de ces jeux recouvrant les faces du dôme central (78).

6. Dispositif transducteur selon la revendication 5, caractérisé en ce que le diaphragme (6) déplace un cône rigide (77) suspendu sous l'action d'une tension électrique de commande appliquée au jeux d'électrodes (5, 7).

7. Dispositif transducteur selon la revendication 5, caractérisé en ce que le diaphragme est couplé mécaniquement à un transducteur électromécanique (74, 75, 79).

8. Dispositif transducteur selon la revendication 7, caractérisé en ce que le transducteur électromécanique est un moteur de haut-parleur entraînant un cône (77) entourant le dôme central (78); le diaphragme faisant office de suspension du cône (77) et de moyen de détection de ses déplacements.

9. Dispositif transducteur selon la revendication 8, caractérisé en ce que le dôme central (78) rayonne les fréquences supérieures de la gamme acoustique et le cône (77) les fréquences inférieures de celle-ci.

10. Dispositif transducteur selon la revendication 1, caractérisé en ce que le protubérance (6) est intercalée entre deux pièces ogivales (70, 71) pouvant se déplacer l'une par rapport à l'autre; la protubérance étant écrasée par ces deux pièces lorsqu'elles subissent une forte décélération afin de libérer une énergie électrique suffisante pour mettre à feu une charge de poudre (73).

11. Dispositif transducteur selon l'une quelconque des revendications 1 à 5, caractérisé en ce que les protubérances (6) ont une face commune destinée à créer une pression acoustique dans le conduit auditif de l'oreille (59); l'autre face commune comprimant l'air (58) enfermé dans un boîtier (55); la pression acoustique étant engendrée sous la commande d'une tension alternative appliquée à des électrodes (57) recouvrant les faces communes; la convexité d'une des protubérances étant dirigée vers le conduit auditif.

12. Dispositif transducteur selon l'une quelconque des revendications 1 à 5, caractérisé en ce que les protubérances (6) ont une face commune destinée à subir l'action d'une pression acoustique incidente; l'autre face commune comprimant l'air contenu dans un boîtier (62) compartimenté, afin d'assurer aux déplacements provoqués par la pression acoustique incidente une réponse régulière en fréquence; des électrodes (6 et 7) disposées sur les faces communes délivrant une tension proportionnelle à la pression acoustique incidente.

13. Dispositif transducteur selon l'une quelconque des revendications 1 à 5, caractérisé en ce que les protubérances (6) ont au moins une face commune rayonnante; les électrodes (5, 7) recevant une tension électrique alternative dans la gamme acoustique ou ultrasonique; la face rayonnante étant en contact avec un fluide compressible ou incompressible dans lequel se propagent les ondes de compression engendrées par le déplacement vibratoire de cette face.

14. Dispositif transducteur selon la revendication 13, caractérisé en ce que l'élément transducteur est monté sur un écran (4).

15. Dispositif transducteur selon la revendication 1, caractérisé en ce que ladite protubérance (6) forme un corps creux dont le volume intérieur (41) varie sous la commande d'une tension électrique appliquée aux électrodes (5, 7); la variation de volume exerçant une poussée sur un liquide.

16. Dispositif transducteur selon la revendication 15, caractérisé en ce que le liquide (46) est contenu dans un tube capillaire (44); la poussée déplacant le ménisque du liquide vers l'extrémité du tube capillaire; un contact électrique (47) placé en vis à vis de cette extrémité étant mouillé par le liquide (46) lorsque la poussée lui fait franchir l'extrémité du tube capillaire (44).

17. Dispositif transducteur selon la revendication 15, caractérisé en ce que la poussée provoque l'émission d'un jet de liquide; la tension électrique étant pulsatoire; le jet étant projeté au moyen d'une buse alimentée par un réservoir de liquide.

18. Dispositif transducteur selon la revendication 1, caractérisé en ce que l'élément transducteur est irradié au moyen d'un rayonnement infrarouge incident (53); les électrodes (5, 7) délivrant une tension électrique en réponse à l'échauffement de la protubérance (6) qui résulte de l'absorption de rayonnement infrarouge incident (53).

19. Dispositif transducteur selon la revendication 18, caractérisé en ce que la protubérance (6) est située au foyer (F) d'un miroir concave (50) qui réfléchit le rayonnement infrarouge transmis par la portion du film polymère (6) entourant la protubérance.

20. Dispositif transducteur selon la revendication 19, caractérisé en ce qu'il comprend au milieu du film polymère (6) un réseau de N protubérances destiné à l'analyse de l'image de la source de rayonnement infrarouge projetée par le miroir (50); les électrodes (5, 7) associées à chacune des N protubérances délivrant N tensions électriques destinées à la visualisation de l'image infrarouge.

21. Dispositif transducteur selon l'une quelconque des revendications 1 à 5, caractérisé en ce qu'il comprend au moins deux éléments transducteurs (5, 6, 7) dont les déformations

17 **0 002 161** 18

sont rendues interdépendantes par un moyen de couplage (101, 102).

22. Dispositif transducteur selon la revendication 21, caractérisé en ce que le moyen de couplage est mécanique (101, 102).

23. Dispositif transducteur selon la revendication 21, caractérisé en ce que le moyen de couplage est un fluide contenu dans au moins une cavité (V₁).

24. Dispositif transducteur selon l'une quelconque des revendications 21 à 23, caractérisé en ce que le moyen de couplage (113) assure un couplage dont les caractéristiques varient en fonction de la fréquence.

25. Procédé de fabrication d'un dispositif transducteur selon l'une quelconque des revendications précédentes, caractérisé en ce qu'il consiste: à thermoformer dans le film polymère (6) au moins une protubérance, l'étirement résultant dudit thermoformage engendrant par l'extension des chaînes macromoléculaires dudit film polymère (6) une anisotropie de structure de la paroi étirée, à polariser électriquement la paroi étirée de cette protubérance et à placer cette paroi entre des électrodes (5, 7) formant condensateur.

26. Procédé de fabrication selon la revendication 25, caractérisé en ce que la thermoformage est réalisé en créant une différence de pression entre deux milieux (25, 27) fluides séparés par le film polymère.

27. Procédé de fabrication selon la revendication 26, caractérisé en ce que l'un au moins des deux milieux fluides est gazeux.

28. Procédé de fabrication selon la revendication 27, caractérisé en ce que la différence de pression est produite par aspiration d'un des deux fluides.

29. Procédé de fabrication selon la revendication 26, caractérisé en ce que les deux milieux fluides sont des liquides (25, 27) portés à la température de ramolissement du filmy polymère.

30. Procédé de fabrication selon la revendication 29, caractérisé en ce que les liquides (25, 27) sont rendus électriquement conducteurs et jouent le rôle d'électrodes liquides dans la phase de polarisation électrique de la paroi étirée.

31. Procédé de fabrication selon la revendication 25, caractérisé en ce que le thermoformage est réalisé par emboutissage au moyen d'un poinçon (30) et d'une matrice (31, 32).

32. Procédé de fabrication selon l'une quelconque des revendications 25 à 31, caractérisé en ce que le thermoformage comporte la formation d'une protubérance primaire et à partir de celle-ci la formation de protubérances secondaires.

33. Procédé de fabrication selon l'une quelconque des revendications 25 à 32, caractérisé en ce que le matériau constituant ledit film polymère (6) est l'un des polymères: chlorure de polyvinyle, fluorure de polyvinylidène, fluorure de polyvinyle, ou un mélange de ces polymères.

**Patentansprüche**

1. Wandlervorrichtung, die gebildet ist aus einem einlagien Film (6) aus Polymermaterial, welches piezoelektrische Eigenschaften aufweisen kann, wenn es in seiner Ebene gestreckt und durch ein elektrisches Feld polarisiert wird, dessen Richtung senkrecht zu seinen Flächen ist, dadurch gekennzeichnet, daß dieser Film wenigstens ein Wandlerelement umfaßt, das aus einem Teil dieses Films (6) besteht, in dem wenigstens eine Ausstülpung durch Warmformer gebildet ist, wobei die so gestreckten Wände dieser Ausstülpung eine selbsttragende Struktur von einer Gestalt bilden, die nicht abwickelbar ist und auf der Elektroden (5, 7) angebracht sind, die einen Kondensator bilden.

2. Wandlervorrichtung nach Anspruch 1, dadurch gekennzeichnet, daß das Wandlerelement mehrere Ausstülpungen aufweist.

3. Wandlervorrichtung nach Anspruch 1, dadurch gekennzeichnet, daß die Ausstülpungen durch ringförmige, aneinandergrenzende Wellungen und durch eine zentrale Kalotte (78) gebildet sind; wobei die Gesamtheit dieser Ausstülpungen eine Membran bildet.

4. Wandlervorrichtung nach Anspruch 3, dadurch gekennzeichnet, daß die Flanken der Wellungen elektrisch polarisiert sind durch elektrische Felder entgegengesetzter Richtungen.

5. Wandlervorrichtung nach Anspruch 4, dadurch gekennzeichnet, daß zwei Elektrodensätze auf den Ausstülpungen angeordnet sind; wobei einer dieser Sätze die Flanken der ringförmigen Wellungen belegt und der andere dieser Sätze die Flächen der zentralen Kalotte (78) bedeckt.

6. Wandlervorrichtung nach Anspruch 5, dadurch gekennzeichnet, daß die Membran (6) einen starren aufgehängten Konus (77) unter der Wirkung einer elektrischen Steuerspannung verschiebt, die an die Elektrodensätze (5, 7) angelegt ist.

7. Wandlervorrichtung nach Anspruch 5, dadurch gekennzeichnet, daß die Membran mechanisch an einen elektromechanischen Wandler (74, 75, 79) angekoppelt ist.

8. Wandlervorrichtung nach Anspruch 7, dadurch gekennzeichnet, daß der elektromechanische Wandler ein Lautsprecher-Treiber ist, der einen Konus (77) antreibt, welcher die zentrale Kalotte (78) umgibt; wobei die Membran zur Aufhängung der Kalotte (77) und als Detektionseinrichtung zur Detektion ihrer Bewegungen dient.

9. Wandlervorrichtung nach Anspruch 8, dadurch gekennzeichnet, daß die zentrale Kalotte (78) die oberen Frequenzen und der Konus (77) die unteren Frequenzen des Schallbereichs abstrahlt.

10. Wandlervorrichtung nach Anspruch 1, dadurch gekennzeichnet, daß die Ausstülpung (6) zwischen zwei spitzbogenförmige Teile (70, 71) eingefügt ist, die sich relativ zueinander bewegen können; wobei die Ausstülpung durch diese beiden Teile zusammengedrückt wird, wenn sie einge starke Abbremsung erfahren, um eine elektrische Energie freizusetzen, die ausreicht, um eien Pulverladung (73) zu zünden.

11. Wandlervorrichtung nach einem der Ansprüche 1 bis 5, dadurch gekennzeichnet, daß die Ausstülpungen (6) eine gemeinsame Fläche aufweisen, die dazu bestimmt ist, einen Schalldruck in dem Gehörgang des Ohres (59) zu erzeugen; wobei die andere gemeinsame Fläche die in einem Gehäuse (55) eingeschlossene Luft (58) komprimiert; wobei der Schalldruck unter Steuerung einer Wechselspannung erzeugt wird, die an Elektroden (57) angelegt wird, welche die gemainsamen Flächen bedecken; wobei die konvexe Seite einer der Ausstülpungen dem Gehörgang zugewendet ist.

12. Wandlervorrichtung nach einem der Ansprüche 1 bis 5, dadurch gekennzeichnet, daß die Ausstülpungen (6) einen gemeinsame Fläche aufweisen, die dazu bestimmt ist, der Wirkung eines einfallenden Schalldrucks ausgesetzt zu werden; während die andere gemeinsame Fläche die Luft komprimiert, die in einem Gehäuse (62) enthalten ist, das mit Abteilen versehen ist, um zu gewährleisten, daß die durch den einfallenden Schalldruck verursachten Bewegungen eine gleichmäßige Frequenzkurve aufweisen; wobei Elektroden (6 und 7), die auf diesen gemeinsamen Flächen angeordnet sind, eine Spannung abgeben, die proportional zu dem einfallenden Schalldruck ist.

13. Wandlervorrichtung nach einem der Ansprüche 1 bis 5, dadurch gekennzeichnet, daß die Ausstülpungen (6) wenigstens eine gemeinsame abstrahlende Fläche aufweisen; wobei die Elektroden (5, 7) eine elektrische Wechselspannung innerhalb des Ultraschallbereichs empfangen; wobei die abstrahlende Fläche in Berührung mit einem kompressiblen oder inkompressiblen fluiden Medium ist, in welchem sich die Kompressionswellen ausbreiten, die durch die Vibrationsbewegung dieser Fläche verursacht werden.

14. Wandlervorrichtung nach Anspruch 13, dadurch gekennzeichnet, daß des Wandlerelement auf einem Schirm (4) angebracht ist.

15. Wandlervorrichtung nach Anspruch 1, dadurch gekennzeichnet, daß die Ausstülpung (6) einen Hohlkörper bildet, dessen Innenvolumen (41) sich unter der Steuerung durch eine an die Elektroden (5, 7) angelegte elektrische Spannung verändert; wobei die Volumenänderung eine Druckwirkung auf eine Flüssigkeit ausübt.

16. Wandlervorrichtung nach Anspruch 15, dadurch gekennzeichnet, daß die Flüssigkeit in einer Kapillare (44) enthalten ist; wobei die Druckwirkung die Flüssigkeitskuppe zu dem Ende der Kapillare hin verschiebt; wobei ein elektrischer Kontakt (47), der gegenüber diesem Ende angeordnet, ist, durch die Flüssigkeit (46) benetzt wird, wenn die auf diese einwirkende Druckwirkung dazu führt, daß sie das Ende der Kapillare (44) überschreitet.

17. Wandlervorrichtung nach Anspruch 15, dadurch gekennzeichnet, daß die Druckwirkung das Ausstoßen eines Flüssigkeitsstrahls verursacht; wobei die elektrische Spannung eine pulsierende Spannung ist; wobei der Strahl durch eine Düse ausgestoßen wird, die aus einem Flüssigkeitsbehälter gespeist wird.

18. Wandlervorrichtung nach Anspruch 1, dadurch gekennzeichnet, daß das Wandlerelement mit einer einfallenden Infrarotstrahlung (53) bestrahlt wird; wobei die Elektroden (5, 7) eine elektrische Spannung abgeben, die auf die Erwärmung der Ausstülpung (6) anspricht, welche durch die Absorption der einfallenden Infrarotstrahlung (53) verursacht wird.

19. Wandlervorrichtung nach Anspruch 18, dadurch gekennzeichnet, daß die Ausstülpung (6) im Brennpunkt (F) eines Konkavspiegels (50) angeordnet ist, welcher die Infrarotstrahlung reflektiert, die durch denjenigen Teil des Polymerfilms (6) durchgelassen wird, welcher die Ausstülpung umgibt.

20. Wandlervorrichtung nach Anspruch 19, dadurch gekennzeichnet, daß sie in der Mitte des Polymerfilms (6) eine netzartige Anordnung von N Ausstülpungen aufweist, die zur Analyse des Bildes der Infrarotstrahlungsquelle bestimmt ist, welches durch den Spiegel (50) projiziert wird; wobei die jeder der N Ausstülpungen zugeordneten Elektroden (5, 7) eine Anzahl von N elektrischen Spannungen abgeben, die zur Sichtbarmachung des Infrarotbildes bestimmt sind.

21. Wandlervorrichtung nach einem der Ansprüche 1 bis 5, dadurch gekennzeichnet, daß sie wenigstens zwei Wandlerelemente (5, 6, 7) umfaßt, deren Deformierungen durch eine Kopplungseinrichtung (101, 102) voneinander abhängig gemacht sind.

22. Wandlervorrichtung nach Anspruch 21, dadurch gekennzeichnet, daß die Kopplungseinrichtung mechanisch ist (101, 102).

23. Wandlervorrichtung nach Anspruch 21, dadurch gekennzeichnet, daß die Kopplungseinrichtung ein fluides Medium ist, das in wenigstens einem Hohlraum ($V_1$) enthalten ist.

24. Wandlervorrichtung nach einem der Ansprüche 21 bis 23, dadurch gekennzeichnet, daß die Kopplungseinrichtung (113) eine Kopplung gewährleistet, deren Kennwerte frequenzabhängig sind.

25. Verfahren zur Herstellung einer Wandlervorrichtung nach einem der vorstehenden Ansprüche, dadurch gekennzeichnet, daß es darin besteht, daß: in dem Polymerfilm (6) wenigstens eine Ausstülpung durch Warmformen gebildet wird, die durch das Warmformen entstandene Streckung durch Dehnung der makromolekularen Ketten des Polymerfilms (6) eine Strukturanisotropie der gestreckten Wandung verursacht, die gestrecke Wandung dieser Ausstülpung elektrisch polarisiert wird und diese Wandung zwischen Elektroden (5, 7) angeordnet wird, welche einen Kondensator bilden.

26. Herstellungsverfahren nach Anspruch 25, dadurch gekennzeichnet, daß das Warmformen erfolgt, indem eine Druckdifferenz zwischen zwei fluiden Medien (25, 27) erzeugt wird, die durch den Polymerfilm getrennt sind.

27. Herstellungsverfahren nach Anspruch 26, dadurch gekennzeichnet, daß wenigstens eines der beiden fluiden Medien gasförmig ist.

28. Herstellungsverfahren nach Anspruch 27, dadurch gekennzeichnet, daß die Druckdifferenz durch Ansaugen eines der beiden fluiden Medien erzeugt wird.

29. Herstellungsverfahren nach Anspruch 26, dadurch gekennzeichnet, daß die beiden fluiden Medien Flüssigkeiten (25, 27) sind, die auf die Erweichungstemperatur des Polymerfilms erwärmt sind.

30. Herstellungsverfahren nach Anspruch 29, dadurch gekennzeichnet, daß die Flüssigkeiten (25, 27) elektrisch leitfähig gemacht sind und in der Phase der elektrischen Polarisierung der gestreckten Wandung die Funktion von flüssigen Elektroden erfüllen.

31. Herstellungsverfahren nach Anspruch 25, dadurch gekennzeichnet, daß das Warmformen durch Tiefziehen mittels eines Stempels (30) und einer Matrixform (31, 32) verwirklicht wird.

32. Herstellungsverfahren nach einem der Ansprüche 25 bis 31, dadurch gekennzeichnet, daß das Warmformen die Bildung einer primären Ausstülpung umfaßt, von der ausgehend die Bildung von sekundären Ausstülpungen erfolgt.

33. Herstellungsverfahren nach einem der Ansprüche 25 bis 32, dadurch gekennzeichnet, daß das Material, aus dem der Polymerfilm (6) gebildet wird, eines der folgenden Polymere ist: Polyvinylchlorid, Polyvinylidenfluorid, Polyvinylfluorid oder ein Gemisch dieser Polymere.

**Claims**

1. Transducer device formed of a single layer film (6) of polymer material susceptible to have piezoelectric properties when it is stretched in its plane and electrically polarized by a field which is normal to its faces, characterized in that this film comprises at least one transducer member formed of a portion of said film (6) in which at least one protuberance has been formed by thermoforming, the thus stretched walls of said protuberance forming a self-supporting structure having a non-developable shape on which electrodes (5, 7) forming a capacitor are located.

2. Tranducer device in accordance with claim 1, characterized in that the transducer member comprises a plurality of protuberances.

3. Transducer device in accordance with claim 1, characterized in that the protuberances are formed by annular contiguous undulations and by a central dome (78); these protuberances together forming a diaphragm.

4. Transducer device in accordance with claim 3, characterized in that the undulations have their flanges electrically polarized by electric fields of opposite senses.

5. Transducer device in accordance with claim 4, characterized in that two sets of electrodes are located on the protuberances; one of these sets covering the faces of the annular undulations and the other of these sets covering the faces of the central dome (78).

6. Transducer device in accordance with claim 5, characterized in that the diaphragm (6) displaces a rigid suspended cone (77) under the action of an electric control voltage applied to the electrode sets (5, 7).

7. Transducer device in accordance with claim 5, characterized in that the diaphragm is mechanically coupled to an electromechanic transducer (74, 75, 79).

8. Transducer device in accordance with claim 7, characterized in that the electromechanic transducer is the driver of a loudspeaker driving a cone (77) surrounding the central dome (78); the diaphragm being used for suspending the cone (77) and detecting its movements.

9. Transducer device in accordance with claim 8, characterized in that the central dome (78) radiates the upper frequencies of the acoustic range and the cone (77) radiates the lower frequencies of said range.

10. Transducer device in accordance with claim 1, characterized in that the protuberance (6) is located between two ogival pieces (70, 71) adapted to move relative to each other; the protuberance being compressed by these pieces when these are subjected to a high deceleration in order to generate sufficient electric energy for ignition of a powder charge (73).

11. Transducer device in accordance with any of claims 1 to 5, characterized in that the protuberances (6) have a common face adapted to generate an acoustic pressure within the auditory canal of the ear (59); the other common face compressing the air (58) enclosed within a housing (55); the acoustic pressure being generated under control of an alternative voltage applied to electrodes (57) covering the common faces; the convex side of one of the protuberances being directed towards the auditory canal.

12. Transducer device in accordance with any of claims 1 to 5, characterized in that the protuberances (6) have a common face adapted to be subjected to the action of an incident acoustic pressure; the other common face compressing the air contained within a housing (62) which is partitioned in order to assure that the displacements caused by the incident acoustic pressure have a regular frequency response; electrodes (6 and 7) located on the common faces delivering a voltage which is proportional to the incident acoustic pressure.

13. Transducer device in accordance with any of claims 1 to 5, characterized in that the protuberances (6) have at least one common radiating face; the electrodes (5, 7) receiving an electric alternative voltage within the ultrasonic acoustic range; the radiating face being in contact with a compressible or incompressible fluid in which compression waves generated by the vibratory displacements of this face are propagated.

14. Transducer device in accordance with claim 13, characterized in that the transducer member is mounted on a screen (4).

15. Transducer device in accordance with claim 1, characterized in that said protuberance (6) forms a hollow body the inside volume (41) of which varies under control of an electric voltage applied to the electrodes (5, 7); the volume variation subjecting a liquid to a pressure action.

16. Transducer device in accordance with claim 15, characterized in that the liquid (46) is contained within a capillary tube (44); the pressure action displacing the meniscus of the liquid towards the end of the capillary tube; an electrical contact (47) facing said end being wettened by the liquid (46) when the pressure action causes the same to move beyond the end of the capillary tube (44).

17. Transducer device in accordance with claim 15, characterized in that the pressure action causes a liquid jet to be expulsed; the electric voltage being pulsating; the jet being projected through a nozzle fed from a liquid container.

18. Transducer device in accordance with claim 1, characterized in that the transducer member is irradiated by incident infrared radiation (53); the electrodes (5, 7) delivering an electric voltage in response to the heating of the protuberance (6) resulting from the absorption of the incident infrared radiation (53).

19. Transducer device in accordance with claim 18, characterized in that the protuberance (6) is located at the focus (F) of a concave mirror (50) reflecting the infrared radiation transmitted through the portion of the polymer film (6) surrounding the protuberance.

20. Transducer device in accordance with claim 19, characterized in that it comprises, at the center of the polymer film (6), a pattern of N protuberances adapted to analyze the image of the infrared radiation source projected by the mirror (50); the electrodes (5, 7) associated with each of said N protuberances delivering N electric voltages for visualization of the infrared image.

21. Transducer device in accordance with any of claims 1 to 5, characterized in that it comprises at least two transducer members (5, 6, 7) the deformations of which are rendered interdependent by coupling means (101, 102).

22. Transducer device in accordance with claim 21, characterized in that the coupling means is mechanical (101, 102).

23. Transducer device in accordance with claim 21, characterized in that the coupling means is a fluid contained within at least one cavity $(V_1)$.

24. Transducer device in accordance with any of claims 21 to 23, characterized in that the coupling means (113) assures a coupling the characteristics of which vary as a function of the frequency.

25. Method of producing a transducer device in accordance with any of the preceding claims, characterized in that it consists in: thermoforming at least one protuberance in the polymer film (6), the stretching resulting from said thermoforming generating a structural anisotropy of the stretched wall by an extension of the macromolecular chains of said polymer film (6), electrically polarizing the stretched wall of said protuberance and placing said wall being electrodes (5, 7) forming a capacitor.

26. Production method in accordance with claim 25, characterized in that the thermoforming is performed by generating a pressure difference between two fluids (25, 27) separated by the polymer film.

27. Production method in accordance with claim 26, characterized in that at least one of the two fluids is gaseous.

28. Production method in accordance with claim 27, characterized in that the pressure difference is produced by aspirating one of the two fluids.

29. Production method in accordance with claim 26, characterized in that the two fluids are liquids (25, 27) heated to the softening temperature of the polymer film.

30. Production method in accordance with claim 29, characterized in that the liquids (25, 27) are rendered electrically conductive to perform as liquid electrodes in the step of electrical polarization of the stretched wall.

31. Production method in accordance with claim 25, characterized in that the thermoforming is produced by deep-drawing using a punch (30) and a die (31, 32).

32. Production method in accordance with any of claims 25 to 31, characterized in that the thermoforming comprises the step of forming a primary protuberance from which secondary protuberances are formed.

33. Production method in accordance with any of claims 25 to 32, characterized in that the material of which the polymer film (6) is formed is one of the following polymers: polyvinyl chloride, polyviniyldene fluoride, polyvinyl fluoride or a mixture of these polymers.

Fig. 1

Fig. 2

HEATER — *15*

*19*

*16*

*23*

*6*

*14*

FIG. 3

*18*

*17* V

*20*

*5*

*22*

*6*

*21*

VOLTAGE SOURCE

*11*

*13*

FIG. 4

Fig. 5

Fig. 6

FIG. 7

VOLTAGE SOURCE

FIG. 8

VOLTAGE SOURCE

FIG. 9

0 002 161

Fig. 10

Fig. 11

5

0 002 161

FIG. 12

FIG. 13

FIG. 14

(a)

(b)

(c)

Fig. 15